Europäisches Patentamt

European Patent Office

Office européen des brevets

(11) Publication number: **0 099 703**
**A2**

## (12) EUROPEAN PATENT APPLICATION

(21) Application number: **83303973.8**

(22) Date of filing: **07.07.83**

(51) Int. Cl.³: **H 03 D 1/00**

(30) Priority: **14.07.82 JP 122633/82**

(43) Date of publication of application:
**01.02.84 Bulletin 84/5**

(84) Designated Contracting States:
**DE FR GB IT NL**

(71) Applicant: **FUJITSU LIMITED**
**1015, Kamikodanaka Nakahara-ku**
**Kawasaki-shi Kanagawa 211(JP)**

(72) Inventor: **Miyo, Tokihiro**
**Fujitsu Ltd. Patent Department 1015 Kamikodanaka**
**Nakahara-ku Kawasaki 211(JP)**

(74) Representative: **Sunderland, James Harry et al,**
**HASELTINE LAKE & CO Hazlitt House 28 Southampton**
**Buildings Chancery Lane**
**London WC2A 1AT(GB)**

(54) **An envelope detector.**

(57) In an envelope detector, signal divider means (9) divide an input signal into a pair of output signals of equal amplitude and equal phase. A reference oscillator (5, 6) provides a pair of reference signals of equal amplitude of phases differing by 90°. In modulating means (7, 7') each output signal is modulated by a respective reference signal to provide modulated signals which are filtered by respective low pass filters (11, 11') to provide base band signals.

The base band signals are squared by squaring circuits (12, 12') and the resulting signals added by an adder circuit (13). The square root of the sum may be provided by a square root circuit (14).

Alternatively, the base band signals are delivered to absoluting circuits (15, 15') to provide their absolute values which are added in an adder circuit (13).

*FIG. 2*

EP 0 099 703 A2

AN ENVELOPE DETECTOR

This invention relates to an envelope detector for extracting or detecting the amplitude envelope of a carrier wave signal for instance.

In modern communication systems envelope detectors must sometimes meet very stringent requirements. For example, a MODEM used for a satellite communication receiver which is operated in a time division multiple access (TDMA) system is required to demodulate preamble word signals. Moreover the MODEM is sometimes required to operate at different bit rates in correspondence to different TDMA groups.

In such situations an envelope detector is required to detect a nonmodulated portion of a preamble word in order that an AFC (automatic frequency control) circuit can be precisely operated. Thus, critical requirements are placed upon band pass filter characteristics provided by the envelope detector.

In a modern carrier wave communication system, the envelope detector in general comprises a serial combination of a band pass filter, a detector or a rectifier, and a low pass filter. However, when such a conventional envelope detector is used to meet the above-mentioned requirements, it is necessary to keep the Q value of the band pass filter very high, and sometimes it is necessary to shift the centre frequency of the band pass filter in correspondence to changes in bit rate. This means that adjustment of the MODEM of the communication system can be very difficult and be troublesome.

According to the present invention there is provided an envelope detector for detecting the amplitude envelope of an input signal, comprising:

a) signal divider means arranged for receiving the input signal and operable to divide the input signal into first and second output signals, of equal power;

b) reference oscillator means operable to provide first and second reference frequency signals, of frequency substantially the same as that of the input signal, of equal power;

c) first and second modulator means, each having first and second inputs and an output, the first and the second inputs of the first modulator means being connected to receive the first output signal and the first reference frequency signal respectively, the first and the second inputs of the second modulator means being connected to receive the second output signal and the second reference frequency signal respectively, whereby the first and second modulator means provide respectively at their outputs a first modulated signal, based on the first output signal and the first reference frequency signal, and a second modulated signal based on the second output signal and the second reference frequency signal;

d) first and second low pass filters operatively connected to the outputs of the first and second modulator means respectively, for filtering harmonic frequency components from the first and second modulated signals, to provide first and second base band signals respectively, the detector being such that the first and second base band signals differ in phase by $90^\circ$; and

e) a full wave rectifying means operatively connected to said first and second low pass filters, to receive the said first and second base band signals, operable to provide a signal proportional to the amplitude envelope of the input signal.

An embodiment of the present invention can provide an envelope detector which is stabilised precisely to a carrier frequency and which effectively has high Q band pass characteristics.

An embodiment of the present invention can provide an envelope detector the band characteristics of which are easy to change by simple adjustment.

An embodiment of the present invention can provide an envelope detector which can be employed in any frequency range from a millimetre wavelength range to an IF frequency range.

An embodiment of the present invention can provide an envelope detector which is easily adjusted and maintained.

An embodiment of the present invention can provide an envelope detector which is useful for a MODEM of a satellite communication system, easy to adjust and easy to maintain.

Embodiments of the present invention are, for example, useful for burst MODEMS (modulator and demodulator) in satellite communication systems or in other phase shift keying (PSK) communication systems operating in micro-wave or millimetre-wave frequency ranges.

Briefly, an embodiment of the present invention functions in two steps. In the first step an input signal is divided into two parts. Each of the divided signals is modulated by a reference signal supplied from a reference oscillator whose frequency is stabilised. For example the reference signal frequency is effectively the same as the input carrier frequency. Means are provided to give the two resulting modulated signals phase angles which differ by 90$^{\circ}$. In the second step those two modulated signals are filtered and processed, utilising their phase difference, to obtain a signal proportional to the envelope of the input carrier signal.

Embodiments of the present invention provide envelope detectors for extracting the voltage envelope of an analog carrier signal.

Reference is made, by way of example, to the accompanying drawings, in which:-

Fig. 1 is a schematic block diagram of a previously proposed envelope detector,

Fig. 2 is a schematic block diagram illustrating the functions provided in an embodiment of the present invention,

Fig. 3 is a schematic block diagram of one envelope detector embodying the present invention,

Fig. 4 is a schematic block diagram of another envelope detector embodying the present invention, and

Fig. 5 is a waveform diagram showing typical waveforms of signals developed in the detector of Fig. 4, and illustrating phase relationships between the signals.

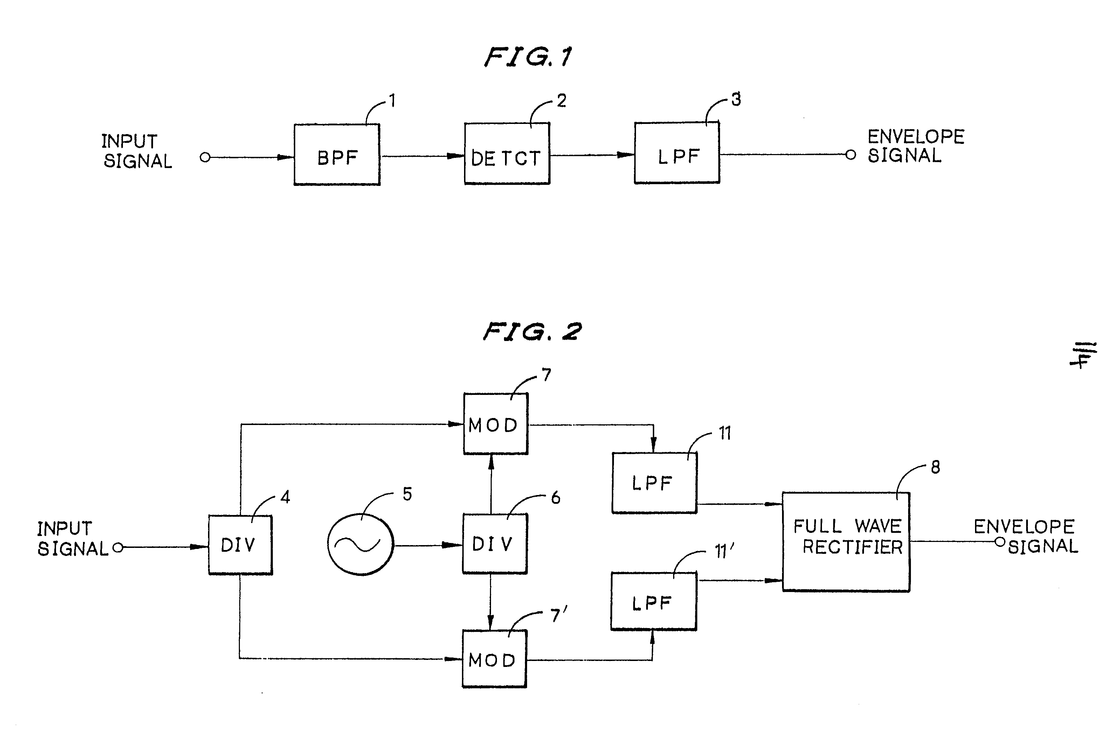

Fig. 1 illustrates the configuration of a previously proposed envelope detector which is made up of a band pass filter 1, a detector or a rectifier 2 and a low pass filter 3 connected in line with one another. Usually such an envelope detector is operated in the intermediate frequency stage of a MODEM of a communication system. That is, a received input signal is mixed with an output of a local oscillator and converted into an IF (intermediate frequency) band signal. The band pass filter 1, operating in the IF band, which is generally chosen to be a few tens of MHz, usually comprises an LC circuit (a network circuit made up of inductors and capacitors). This means that the Q value of the band pass filter is about 100 at most, and it is difficult to maintain a higher Q value.

Moreover, there is another difficulty: if the Q value of the band pass filter is made very high, even a slight shift in the local oscillator frequency or in the input carrier signal frequency may cause mis-tuning of the system. This means that circuitry adjustment is very critical and maintenance of the system is difficult.

In embodiments of the present invention operated for example in the input signal frequency range, an input signal is modulated by an output of an oscillator whose frequency is the same or substantially the same as that of the input carrier frequency. The input signal is thus converted into a base band signal and envelope detection is effected in the base band frequency range. The band pass filter 1 in the detector of Fig. 1 is effectively replaced in embodiments of the present invention by a low pass filter. This means that the effective pass band of the envelope detector is determined by the frequency characteristics of the low pass filter, which is usually made up of a CR network (a network of capacitors and resistors). The cut-off characteristics of the base band low pass filter can be made very sharp, and the effective pass band of the envelope detector embodying the present invention can be very narrow with sharp cut-off characteristics. This effectively corresponds to the realisation of a very high Q band pass filter.

Moreover, it is easy to change the band pass characteristics of a base band low pass filter by modification of its CR circuit network. It is thus easy to realise an envelope detector in accordance with the present invention which can handle a signal which requires the change of band width.

Further, in embodiments of the present invention the local oscillator is oscillated for example at the same frequency as the carrier frequency of the input signal. Hereinafter, the local oscillator is called the reference oscillator. The oscillation frequency of the reference oscillator is easily stabilised by using a crystal oscillator for example. So the envelope detector can be tuned to the input signal frequency and adjustment is easy.

Although the embodiments of the present invention mentioned above are indicated to operate in the input signal frequency range; that is, the frequency of the reference oscillator is the same as the input carrier frequency, envelope detectors embodying the present invention can be provided which operate in any frequency range, according to system requirements and design convenience. For example, operation in an intermediate frequency range can be provided.

With reference to Fig. 2, basic functions of an embodiment of the present invention will be described. First, an input signal is divided by a divider 4 into two parts which are led to a first modulator 7 and a second modulator 7' respectively. A reference oscillator 5 oscillates at the frequency of the input carrier signal. It is preferable to stabilise the frequency of the reference oscillator using some means such as a crystal oscillator for example. The output of the reference oscillator is divided by a divider 6 into two parts of equal amplitude. The divided parts of the output of the reference oscillator are provided with phase angles which differ by $90^{\circ}$ by the divider 6. The divided parts of the output of the reference oscillator are fed to the first modulator 7 and to the second modulator 7' respectively, and modulate the divided parts of the input signal. Thus, the outputs of modulators 7 and 7' are signals including base band signals having phase angles which differ by $90^{\circ}$.

A first mixed signal provided by the first modulator 7, and a second mixed signal provided by the second modulator 7' are fed to respective members of a pair of low pass filters 11 and 11' to obtain therefrom first and second base band signals. The base band signals have phase angles which differ by $90^{\circ}$.

As will be understood from the above explanation, there is first obtained a pair of base band signals which have phase angles differing by $90^{\circ}$.

This can be achieved by various circuit configurations modified with respect to that of Fig. 2. For example phase angles differing by $90^{\circ}$ can be provided at the divider 4, if the divider 6 does not provide for this phase difference, or a $90^{\circ}$ phase shifter may be placed at an appropriate point in the circuitry. However, with such modifications the divider 4 must have a wider band pass characteristic as compared with the divider 6, because the former must handle the input signal whilst the latter handles only the single frequency of the reference oscillator. The need for a phase shifter can be eliminated by using a quadrature phase divider. It is believed that the circuit configuration described with reference to Fig. 2 offers advantages in terms of simplicity and balance of the circuit.

As noted above, embodiments of the present invention can operate in any frequency band merely by choosing suitably the frequency of the reference oscillator. Thus, for example, envelope detection can be effected directly in the radio frequency band of an input signal, or in an IF band, whichever is more convenient or easier from the point of view of circuit structure. Moreover, in an embodiment in which envelope detection is effected in the radio frequency band, the frequency of the reference oscillator need not necessarily be exactly the same as that of the input carrier frequency. The requirement which must be met by the reference oscillator is that it should provide a signal of a frequency substantially the same as the input carrier frequency, in order to convert the input signal into the pass band of the low pass filters 11 and 11'. This will be explained in more detail below.

In the basic functions of the embodiment of the present invention described with reference to Fig. 2, after the first and second base band signals differing in phase by $90^{\circ}$ are first obtained, the first base band signal is filtered by a first low pass filter 11 and the second base band signal is filtered by a second low pass filter 11' and the filtered signals are processed utilising their $90^{\circ}$ phase difference. The process involved is a so-called full wave rectification process schematically indicated as being carried out by a full wave rectifier 8 in Fig. 2.

Such processing may be carried out in two different ways. One way involves squaring each of the base band signals, adding together the squared signals and then extracting the square root of the sum. The other way involves extracting the absolute value of the amplitude of each base band signal and adding the absolute values together.

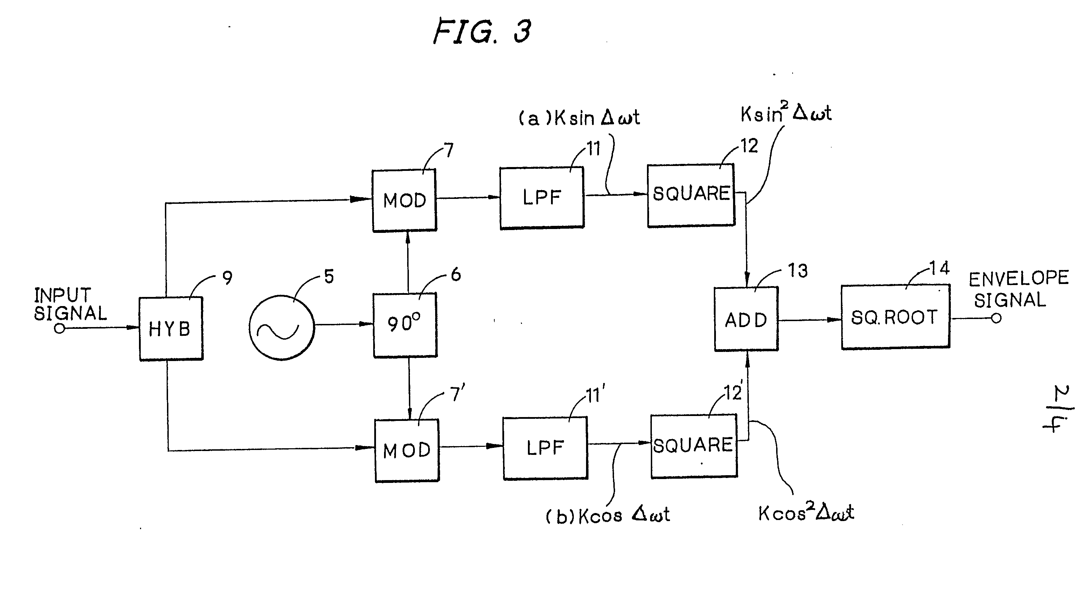

An embodiment of the present invention will be described in more detail with reference to Fig. 3. The embodiment of Fig. 3 is described on the assumption that the envelope detector operates in an IF frequency range. However, as previously mentioned, embodiments of the present invention can operate in any frequency band, so it should be understood that the embodiment of Fig. 3 is described as operating in the IF range by way of an example only.

In Fig. 3, an input signal is fed to a divider comprising for example a hybrid transformer 9, which divides the input signal into first and the second output signals of equal power and equal phase. The divider may be of a type other than a hybrid transformer type. For example it may be a tee divider, resistor divider or any other device appropriate for the purpose.

A reference oscillator 5 oscillates at substantially the same frequency to the carrier frequency of the input signal. In the present example, this is an IF frequency. The frequency of the reference oscillator is stabilised appropriately by a crystal oscillator (not shown).

The output of the reference oscillator is divided by a quadrature phase power divider 6 into first and second reference frequency signals of equal power but of phase angles differing by $90^{\circ}$.

The first and the second output signals are modulated in a first modulator 7 and a second modulator 7' by the first and the second reference frequency signals respectively, to provide first and second modulated signals respectively. Each of the modulators 7 and 7' is preferably a double balanced mixer.

The first and the second modulated signals comprise base band signals and higher frequency signal components. They are therefore filtered by respective low pass filters 11 and 11' to provide first and the second base band signals. It will be clear that the first and second base band signals have a same amplitude but have phase angles differing by 90°.

The first and the second base band signals are squared by a first squaring circuit 12 and a second squaring circuit 12' respectively, and the squared signals are supplied to an adder circuit 13. The output signal amplitude of the adder circuit 13 is proportional to the square of the amplitude envelope of the input signal.

In many applications, for example for obtaining a timing pulse for system synchronisation, this output signal may be utilised directly.

However, if a precise envelope signal is required, the square root of the output signal of the adder circuit 13 is taken. A square root circuit 14 is provided in Fig. 3 for this purpose. Thus, a signal whose amplitude is proportional to the amplitude envelope of the input signal is obtained from the output of the square root circuit 14.

The above mentioned quadrature phase power divider 6, hybrid transformer 9, and modulators 7 and 7' may be of any appropriate type, made up of lumped constant circuits or of distributed constant circuits depending on the operating frequency range of the circuitry and circuit design. The low pass filters 11 and 11', the squaring circuits 12 and 12', the adder circuit 13 and the square root circuit 14 may by of any appropriate type. Sometimes it is convenient to use integrated circuits (IC) for this purpose.

As previously mentioned, the band pass characteristics of the low pass filters 11 and 11' can be easily modified. Thus, it is possible to provide an envelope detector which has effectively a very high Q and variable band pass characteristics.

Signal processing as carried out in the embodiment of Fig. 3 will now be described on a mathematical basis.

If the difference between the angular frequencies of the input carrier signal and the reference signal provided by the reference oscillator is $\Delta\omega$, and the amplitudes of the first and the second base band signals are $e_1$ and $e_2$ respectively, then

$$e_1 = K\sin\Delta\omega t$$

and

$$e_2 = K\cos\Delta\omega t$$

because the phase angles of the first and the second base band signals differ by $90^\circ$. In the above equations K is a constant proportional to the envelope of the input signal.

The output signals of the above-mentioned squaring circuits 12 and 12' are respectively

$$e_1^2 = K^2\sin^2\Delta\omega t$$

and

$$e_2^2 = K^2\cos^2\Delta\omega t.$$

The sum of these two signals as provided by the adder circuit 13 is

$$e_1^2 + e_2^2 = K^2(\sin^2\Delta\omega t + \cos^2\Delta\omega t).$$

Thus, $e_0$, the square root of the sum signal, as provided by the square root circuit 14, is

$$e_0 = \sqrt{K^2(\sin^2 \Delta\omega t + \cos^2 \Delta\omega t)} = K.$$

Thus, a signal whose amplitude is proportional to the amplitude of input signal is obtained.

As will be seen from the above equations, the output signal of the envelope detector is not dependent upon $\Delta\omega$. This means a difference between the angular frequency of the input signal and of the signal from the reference oscillator does not affect the amplitude detection. It is therefore not necessary to adjust the oscillation frequency of the reference oscillator to be precisely equal to the frequency of the input signal.

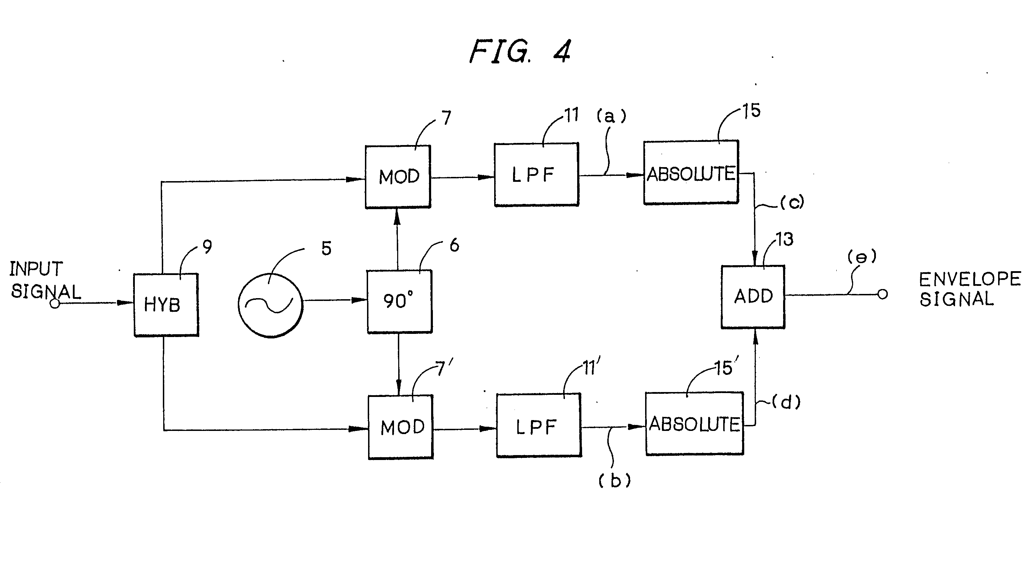

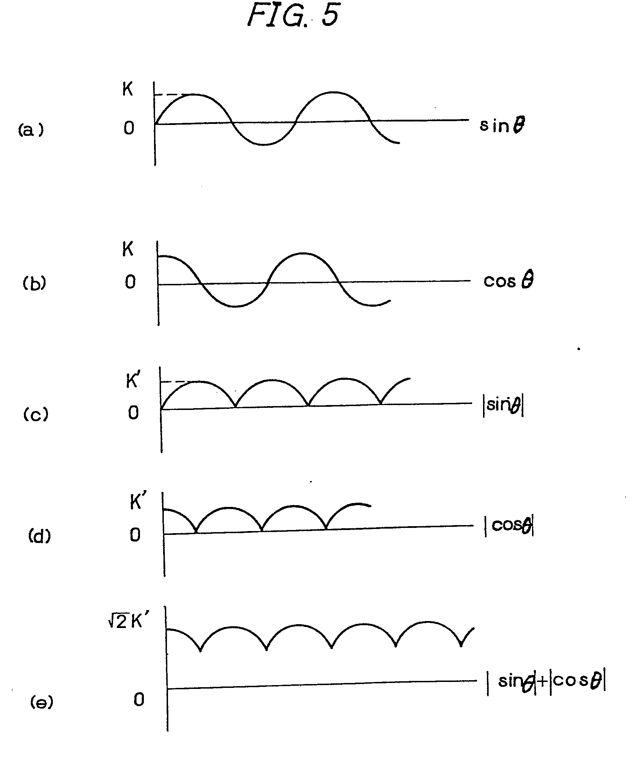

Another embodiment of the present invention will now be explained with reference to Figs. 4 and 5. Fig. 4 is a schematic block circuit diagram of the embodiment and Fig. 5 shows waveforms  of and phase relationships between signals developed at points in the circuit of Fig. 4.

In comparison with Fig. 3, in Fig. 4 the squaring circuits 12 and 12' are replaced by a first absoluting circuit 15 and a second absoluting circuit 15' respectively. The input of each absoluting circuit is operatively connected to the output of a respective low pass filter (11 or 11') and the output of each absoluting circuit is connected to adder circuit 13.

Full wave rectification in the embodiment of Fig. 4 is provided as follows. The waveforms and mutual phase relationships of the first and the second base band signals at circuit points (a) and (b) in Fig. 4 are shown in Fig. 5 by waveforms (a) and (b) respectively. The first and the second base band signals are represented by sine and cosine curves because of their $90^\circ$ phase difference. In the waveforms (a) and (b), K on the vertical axis represents the amplitude of the base band signals, which is proportional to the amplitude of the input signal.

Each of the base band signals is full wave rectified and absolute values are extracted by respective absoluting circuits 15 and 15'. The waveforms and the mutual phase relationship of the first and second absolute value signals, which appear at circuit points (c) and (d) in Fig. 4, are shown by waveforms (c) and (d) in Fig. 5 respectively. In those waveforms K' on the vertical axis represents the peak value of the absolute value signals, which is also proportional to the amplitude of the input signal.

The two absolute value signals are supplied to the adder circuit 13 and added together. The output signal of the adder circuit 13 is shown in waveform (e) in Fig. 5. The maximum value of the output signal is 2K' which is proportional to the amplitude of the input signal. Thus the envelope of the input signal is obtained.

It should be noted that waveform (e) is not exactly the envelope of the input signal.

The waveform (e) has a ripple as shown. The pitch of the ripple is very long as compared with the wavelength of the amplitude modulation signal of the input signal. This will be easily understood by noting that the ripple frequency of the waveform (e) in Fig. 5 corresponds to twice the frequency difference between the input signal and the signal provided by the reference oscillator. This difference is almost zero or very small compared to the frequency of the amplitude modulation input signal. Thus, the ripple varies very slowly, and if the frequency of the reference oscillator is equal to that of the input carrier signal, there will be no ripple; that is, a zero or direct current (DC) signal is obtained. It should be noted that, although the ripple is very slow, or a DC signal is provided, the height of the DC signal or the amplitude K' of the waveform (e) varies rapidly in correspondence with the amplitude of the input signal.

The above-mentioned ripple is so slow that it is practically impossible to smooth it by means of a filter or using a peak detector. Thus, the output signal of the adder circuit 13 in Fig. 4 may be considered to be, in substance, the envelope of the input carrier signal, and no problems arise in practical applications.

With reference to Figs. 4 and 5, it should be noted that each of the output signals of the first and the second absolute value circuits has the amplitude K' proportional to the input signal envelope. However, those signals cannot be used directly for present envelope detection purposes. This is because they vary with a long period with periods of zero output. However, when the absolute value signals are added together, as described above, no such problem arises.

As will be understood from the above description, embodiments of the present invention can provide envelope detectors operable in any frequency range, having effectively very high Q values, and having variable band pass characteristics, which are easy to adjust and easy to maintain.

The present invention relates to an envelope detector for extracting the voltage envelope of an analog modulated carrier signal. Envelope detection is carried out in two stages.

In the first stage an input signal is divided into a pair of signals, of equal amplitude and of equal phase, which are led to respective modulators. Each signal is modulated by a respective one of a pair of reference signals, whose frequencies are equal to that of the input carrier signal which are of equal amplitude but which have phase angles differing by 90$^\circ$. The outputs of both of the modulators are filtered by respective low pass filters. Thus, two base band signals are obtained whose amplitudes are equal but whose phase angles differ by 90$^\circ$.

In the second stage two different processings are possible.

One involves squaring each of the base band signals, adding the squared signals and, if necessary, taking a square root of the sum. The other process involves taking the absolute value of each of the base band signals and adding the absolute values together.

By changing the frequency of the reference oscillator, the envelope detector can be operated in any frequency band from the micro-wave band to an IF band.

By varying the frequency characteristics of the low pass filters, it is possible to provide an envelope detector having easily changeable band pass characteristics and having effectively a very high Q, which is preferable in modern PSK systems.

CLAIMS

1. An envelope detector for detecting the amplitude envelope of an input signal, comprising:

a) signal divider means arranged for receiving the input signal and operable to divide the input signal into first and second output signals, of equal power;

b) reference oscillator means operable to provide first and second reference frequency signals, of frequency substantially the same as that of the input signal, of equal power;

c) first and second modulator means, each having first and second inputs and an output, the first and the second inputs of the first modulator means being connected to receive the first output signal and the first reference frequency signal respectively, the first and the second inputs of the second modulator means being connected to receive the second output signal and the second reference frequency signal respectively, whereby the first and second modulator means provide respectively at their outputs a first modulated signal, based on the first output signal and the first reference frequency signal, and a second modulated signal based on the second output signal and the second reference frequency signal;

d) first and second low pass filters operatively connected to the outputs of the first and second modulator means respectively, for filtering harmonic frequency components from the first and second modulated signals, to provide first and second base band signals respectively, the detector being such that the first and second base band signals differ in phase by $90^{\circ}$; and

e) a full wave rectifying means operatively connected to said first and second low pass filters, to receive the said first and second base band signals, operable to provide a signal proportional to the amplitude envelope of the input signal.

2. An envelope detector as claimed in claim 1, wherein the signal divider provides the first and second output signals with equal phase, and the reference oscillator provides the first and second reference signals with phases differing by $90^O$.

3. An envelope detector as claimed in claim 1 or 2, wherein the full wave rectifying means comprises:

first and second squaring circuits operatively connected to the first and the second low pass filters respectively to receive the first and second base band signals, to provide first and the second squared signals respectively; and

an adder circuit connected to said first and second squaring circuits to receive the first and second squared signals, operable to provide a sum signal of the first and second squared signals.

4. An envelope detector as claimed in claim 3, further comprising a square root circuit operatively connected to said adder circuit to receive the sum signal from said adder circuit, operable to provide a signal proportional to the envelope of the amplitude of the input analog carrier signal.

5. An envelope detector as claimed in claim 1 or 2, wherein the full wave rectifying means comprises:

first and second absoluting circuits, operatively connected respectively to said first and second low pass filters to receive the first and the second base band signals, operable to provide first and second absolute value signals respectively; and

an adder circuit operatively connected to said first and second absoluting circuits, operable to provide a sum signal of the first and second absolute value signals.

6. An envelope detector as claimed in claim 1, 2, 3, 4 or 5, wherein said first and second modulator means are of a double balanced type.

7. An envelope detector as claimed in any preceding claim, wherein the signal divider comprises hybrid circuit means.

8. An envelope detector as claimed in any preceding claim, adapted for envelope detection in respect of an analog carrier wave input signal.

# FIG.1

INPUT SIGNAL ○ → **BPF** (1) → **DETCT** (2) → **LPF** (3) → ○ ENVELOPE SIGNAL

# FIG. 2

INPUT SIGNAL ○ → **DIV** (4) → **MOD** (7) → **LPF** (11) → **FULL WAVE RECTIFIER** (8) → ○ ENVELOPE SIGNAL

(5) → **DIV** (6) → **MOD** (7') → **LPF** (11')

# FIG. 3

INPUT SIGNAL

HYB 9

5

90° 6

MOD 7

LPF 11 — (a) K sin $\Delta\omega t$

SQUARE 12 — K sin$^2$ $\Delta\omega t$

MOD 7'

LPF 11' — (b) K cos $\Delta\omega t$

SQUARE 12' — K cos$^2$ $\Delta\omega t$

ADD 13

SQ. ROOT 14

ENVELOPE SIGNAL

2/4

0099703

# FIG. 4

INPUT SIGNAL → HYB (9) → MOD (7) → LPF (11) (a) → ABSOLUTE (15) (c) → ADD (13) → (e) ENVELOPE SIGNAL

(5) → 90° (6) → MOD (7') → LPF (11') (b) → ABSOLUTE (15') (d) → ADD (13)

3/4

4/4

*FIG. 5*

(a)    $K$   $0$         $\sin\theta$

(b)    $K$   $0$         $\cos\theta$

(c)    $K'$   $0$         $|\sin\theta|$

(d)    $K'$   $0$         $|\cos\theta|$

(e)    $\sqrt{2}\,K'$   $0$         $|\sin\theta|+|\cos\theta|$